# EUROPEAN PATENT APPLICATION

(11) **EP 4 598 304 A1**
(43) Date of publication of application: **06.08.2025**
(21) Application number: 25154041.5
(22) Date of filing: 27.01.2025
(51) Int. Cl.: H10D 84/01, H10D 84/03, H10D 84/83, H10D 84/85, H10D 88/00

(54) **TRANSISTOR DEVICE HAVING LOW DIELECTRIC CONSTANT ISOLATION REGION, AND FABRICATION METHOD THEREOF**

(30) Priority: 05.02.2024 US 202463549685 P; 14.06.2024 US 202418743603
(71) Applicant: Samsung Electronics Co., Ltd., Suwon-si, Gyeonggi-do 16677 (KR)
(72) Inventor: YANG, Myung, San Jose, CA 95134 (US); SONG, Seungmin, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Transistor devices are provided. A transistor device includes a substrate and a transistor stack on the substrate. The transistor stack includes a lower transistor and an upper transistor that is on top of the lower transistor. Moreover, the transistor device includes an isolation region that separates the upper transistor from the lower transistor. The isolation region has a dielectric constant that is lower than that of silicon nitride and lower than that of silicon boron carbonitride. Related methods of forming transistor devices are also provided.

## Description

### TECHNICAL FIELD

The present disclosure generally relates to the field of semiconductor devices and, more particularly, to three-dimensional transistor structures.

### BACKGROUND OF THE INVENTION

The size of transistors in integrated circuit (IC) devices has continued to decrease to down-scale logic elements. This has resulted in the development of gate-all-around (GAA) structures, such as multi-bridge channel field-effect transistors (MBCFETs^{™}) and nanosheet FETs (NSFETs). Moreover, as technology to increase transistor density has continued to develop, three-dimensional device structures, such as stacked transistors, are under consideration.

A stacked transistor may include a first transistor and a second transistor. The first transistor may be a first type of transistor (e.g., an n-type metal-oxide-semiconductor (NMOS) transistor) and the second transistor may be a second type of transistor (e.g., a p-type metal-oxide-semiconductor (PMOS) transistor). The first and second types of transistors may be complementary to each other, and thus may be part of a complementary metal-oxide-semiconductor (CMOS) IC. The first and second transistors may be stacked in any order (e.g., first on top of second, or second on top of first), thereby resulting in a stack comprising a top/upper transistor and a bottom/lower transistor.

### SUMMARY OF THE INVENTION

A transistor device, according to some embodiments herein, may include a substrate and a transistor stack on the substrate. The transistor stack may include a lower transistor and an upper transistor that is on top of the lower transistor. The upper transistor and the lower transistor may each include semiconductor channel layers. The transistor device may include a bottom isolation region between the substrate and the semiconductor channel layers of the lower transistor. Moreover, the transistor device may include a middle isolation region between the upper transistor and the lower transistor. The middle isolation region and the bottom isolation region may each have an inner portion that has a dielectric constant that is lower than that of silicon nitride and lower than that of silicon boron carbonitride.

A transistor device, according to some embodiments herein, may include a substrate and a transistor stack on the substrate. The transistor stack may include a lower transistor and an upper transistor that is on top of the lower transistor. Moreover, the transistor device may include a middle dielectric isolation (MDI) region that separates the upper transistor from the lower transistor. The MDI region may have a dielectric constant that is lower than that of silicon nitride and lower than that of silicon boron carbonitride.

A method of forming a transistor device, according to some embodiments herein, may include forming a middle isolation region that separates upper semiconductor channel layers of an upper transistor from lower semiconductor channel layers of a lower transistor. Forming the middle isolation region may include forming a first insulating material between the upper semiconductor channel layers and the lower semiconductor channel layers. Moreover, forming the middle isolation region may include forming a second insulating material on a sidewall of the first insulating material and between an upper surface and a lower surface of the first insulating material. The second insulating material may have a lower dielectric constant than the first insulating material.

### BRIEF DESCRIPTION OF THE DRAWINGS

FIG. 1A is a schematic block diagram of a transistor stack of a transistor device according to some embodiments herein.
FIG. 1B is a cross-sectional view showing further details of the transistor stack of FIG. 1A.
FIGs. 1C-1H are cross-sectional views of different examples of the middle isolation region of FIG. 1B.
FIGs. 2A-2D are cross-sectional views illustrating operations of forming the transistor stack of FIG. 1B.
FIGs. 3A and 3B are flowcharts corresponding to the operations shown in FIGs. 2A-2D.

### DETAILED DESCRIPTION

Pursuant to embodiments herein, transistor devices are provided that include an MDI region, and/or a bottom dielectric isolation (BDI) region, having a relatively low dielectric constant. Though a conventional MDI region separates an upper transistor of a transistor stack from a lower transistor of the transistor stack, the conventional MDI region may have a relatively high dielectric constant and may thereby result in an undesirably-high capacitance. Moreover, though a conventional BDI region separates the lower transistor from a substrate, the conventional BDI region may have a relatively high dielectric constant and may thereby result in an undesirably-high capacitance. An MDI region and/or a BDI region according to embodiments herein, however, may reduce capacitance by including a portion that has a lower dielectric constant than silicon nitride (e.g., Si₃N₄) and/or silicon boron carbonitride (e.g., SiBCN), as capacitance is directly proportional to dielectric constant.

For example, an MDI region, and/or a BDI region, according to embodiments herein may include an inner portion and an outer portion, where the inner portion has a lower dielectric constant than the outer portion. In some embodiments, the inner portion may include an oxide, such as silicon oxide (e.g., Si0₂). As an example, the outer portion and the inner portion may collectively provide a nitride-oxide-nitride (NON) structure for the MDI region and/or the BDI region, as an oxide of the inner portion may be bounded by a nitride of the outer portion on multiple sides. In other embodiments, the inner portion may include a vacancy, such as an air gap. Though the outer portion may include an insulating material having a high dielectric constant, such as silicon nitride or silicon boron carbonitride, the inner portion may include a material (or a vacancy) having a low (or relatively lower) dielectric constant, which can reduce an overall dielectric constant of, and thus a capacitance resulting from (e.g., dependent on), the MDI region and/or the BDI region. Moreover, reducing a capacitance of the MDI region and/or the BDI region may improve performance of a device including a transistor stack that includes the MDI region and/or the BDI region.

Example embodiments will be described in greater detail with reference to the attached figures.

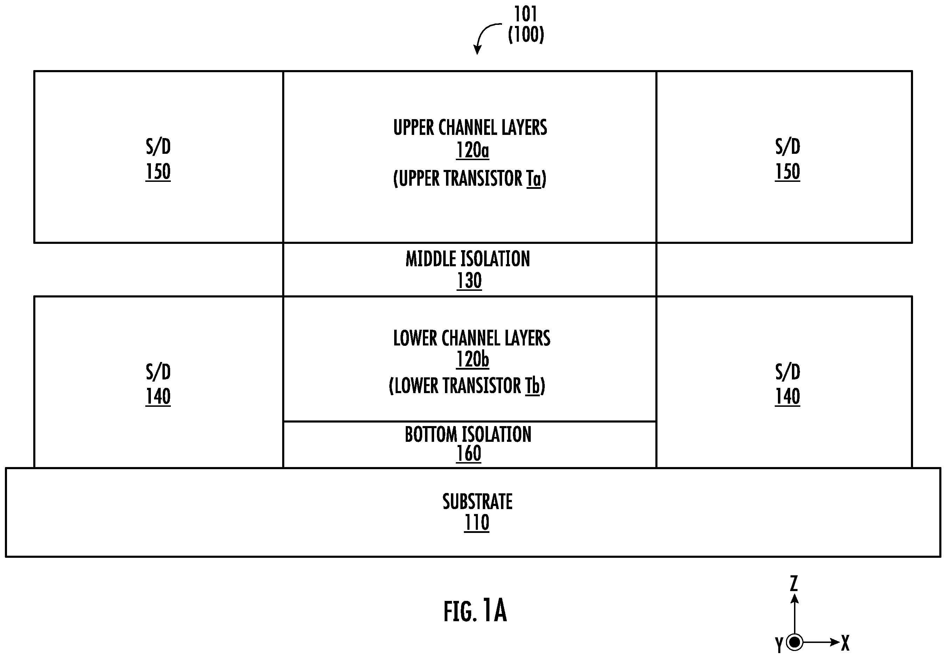

FIG. 1A is a schematic block diagram of a transistor stack 101 of a transistor device 100 according to some embodiments herein. The transistor stack 101 includes a lower transistor Tb having a stack of lower semiconductor channel layers 120b and an upper transistor Ta having a stack of upper semiconductor channel layers 120a. The channel layers 120a, 120b may comprise, for example, silicon and may be free of germanium and carbon. The lower transistor Tb is between, in a vertical direction Z, the upper transistor Ta and a substrate 110 (e.g., a silicon, or other semiconductor, substrate). A middle isolation (e.g., MDI) region 130 may be between, in the vertical direction Z, the upper and lower transistors Ta, Tb. The middle isolation region 130 may also be referred to herein as an "insulating spacer," as it spaces the upper transistor Ta apart from the lower transistor Tb. Moreover, a bottom isolation (e.g., BDI) region 160 may be between, in the vertical direction Z, the lower transistor Tb and the substrate 110.

The lower channel layers 120b of the lower transistor Tb are between, in a first horizontal (i.e., lateral) direction X, a pair of lower source/drain (S/D) regions 140 that are electrically connected to the lower channel layers 120b. The first horizontal direction X and the vertical direction Z may be perpendicular to each other, and a second horizontal (i.e., lateral) direction Y may be perpendicular to each of the first horizontal direction X and the vertical direction Z. Each lower channel layer 120b may be implemented by, for example, a nanosheet or nanowire between the lower S/D regions 140. Likewise, the upper channel layers 120a of the upper transistor Ta may be between, in the first horizontal direction X, a pair of upper S/D regions 150 that are electrically connected to the upper channel layers 120a, and each upper channel layer 120a may be implemented by, for example, a nanosheet or nanowire between the upper S/D regions 150.

In some embodiments, the upper S/D regions 150 may include a different semiconductor material from that of the lower S/D regions 140. As an example, the upper S/D regions 150 may include silicon germanium, and the lower S/D regions 140 may include silicon carbide, or vice versa. In other embodiments, the upper S/D regions 150 may include the same semiconductor material as the lower S/D regions 140. According to some embodiments, an insulating/isolation region may be between, in the direction Z, the lower S/D regions 140 and the upper S/D regions 150. For simplicity of illustration, however, a material intervening between the lower S/D regions 140 and the upper S/D regions 150 is omitted from view in FIG. 1A.

For further simplicity of illustration, only one transistor stack 101 is shown in FIG. 1A. According to some embodiments, however, the device 100 may include two, three, four, or more transistor stacks 101.

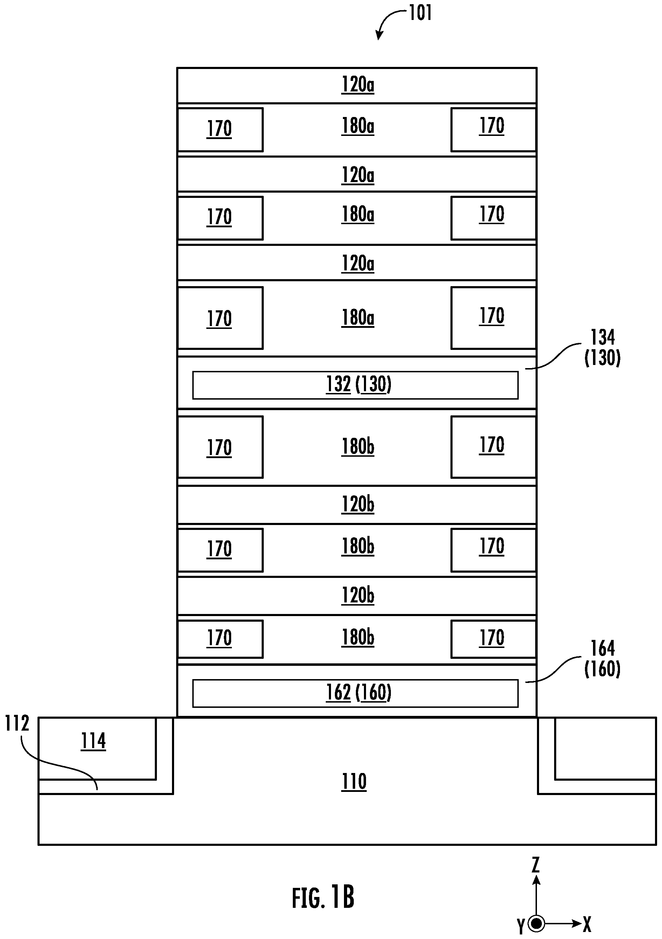

FIG. 1B is a cross-sectional view showing further details of the transistor stack 101. As shown in FIG. 1B, the upper transistor Ta (FIG. 1A) of the transistor stack 101 may include an upper gate 180a that is on the upper channel layers 120a. For example, the upper gate 180a may be between the channel layers 120a. Likewise, the lower transistor Tb (FIG. 1A) of the transistor stack 101 may include a lower gate 180b that is on (e.g., between) the lower channel layers 120b.

The lower gate 180b may be spaced apart from the lower S/D regions 140 (FIG. 1A) in the horizontal direction X by insulating spacers 170. The spacers 170 may be on sidewalls of the lower gate 180b and between, in the vertical direction Z, the lower channel layers 120b. Likewise, the upper gate 180a may be spaced apart from upper S/D regions 150 (FIG. 1A) in the horizontal direction X by insulating spacers 170, which may be on sidewalls of the upper gate 180a and between, in the vertical direction Z, the upper channel layers 120a. In some embodiments, the spacers 170 may contact the lower S/D regions 140, the upper S/D regions 150, and the sidewalls of the gates 180a, 180b. Sidewalls of the lower channel layers 120b may contact the lower S/D regions 140, and sidewalls of the upper channel layers 120a may contact the upper S/D regions 150.

The gates 180a, 180b may include a conductive (e.g., metal) material. Moreover, the gates 180a, 180b may, in some embodiments, constitute a single gate (e.g., a shared gate 180a/180b).

The bottom isolation region 160 may be between, in the vertical direction Z, the substrate 110 and the channel layers 120b. In some embodiments, the bottom isolation region 160 may be between, in the vertical direction Z, the substrate 110 and the gate 180b. The bottom isolation region 160 includes an outer portion 164 including an insulating material, such as silicon nitride. The bottom isolation region 160 also includes an inner portion 162 that has a lower dielectric constant than the outer portion 164. For example, the dielectric constant of the inner portion 162 may be (i) lower than a dielectric constant of silicon nitride and (ii) lower than a dielectric constant of silicon boron carbonitride.

The middle isolation region 130 may be between, in the vertical direction Z, the lower transistor Tb and the upper transistor Ta, such as between an uppermost one of the lower channel layers 120b and a lowermost one of the upper channel layers 120a. In some embodiments, the middle isolation region 130 may be between, in the vertical direction Z, the lower gate 180b and the upper gate 180a. The middle isolation region 130 includes an outer portion 134 including an insulating material, such as silicon boron carbonitride. In some embodiments, the insulating material of the outer portion 134 is different from that of the outer portion 164 of the bottom isolation region 160. The middle isolation region 130 also includes an inner portion 132 that has a lower dielectric constant than the outer portion 134. For example, the dielectric constant of the inner portion 132 may be (i) lower than a dielectric constant of silicon nitride and (ii) lower than a dielectric constant of silicon boron carbonitride.

Accordingly, the middle isolation region 130 and the bottom isolation region 160 may, in some embodiments, each include an outer portion and an inner portion that has a lower dielectric constant than the outer portion. For example, the outer portion may include an insulating material, such as silicon nitride or silicon boron carbonitride, and the inner portion may include an oxide (e.g., silicon oxide) or a vacancy. The outer portion may thus include a nitride (and/or carbon). In contrast, the inner portion may be free of carbon and free of nitrogen.

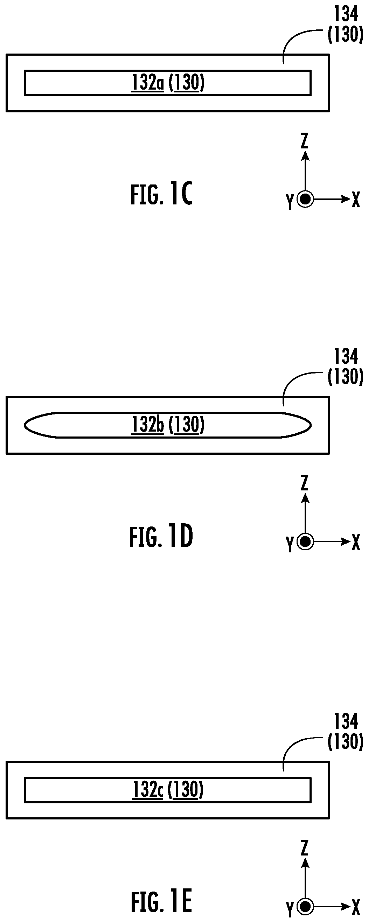

The inner portion may be an interior (e.g., center/middle) portion that is bounded on at least two sides by the outer portion. As a result, the inner portion 132 of the middle isolation region 130 may be spaced apart, in the vertical direction Z, from the upper gate 180a and the lower gate 180b by the outer portion 134 of the middle isolation region 130. Moreover, the inner portion 162 of the bottom isolation region 160 may be spaced apart, in the vertical direction Z, from the lower gate 180b and the substrate 110 by the outer portion 164 of the bottom isolation region 160. Examples of inner and outer portions of an isolation region are discussed in more detail with respect to FIGs. 1C-1H.

Moreover, the spacers 170 may comprise, for example, nitrogen (e.g., silicon nitride). The spacers 170 may also be referred to herein as "inner spacers," as they can be situated between nanosheet/nanowire channels within a transistor. In some embodiments, an uppermost surface of the middle isolation region 130 may contact a lowermost surface of a spacer 170 that is on the upper gate 180a, and a lowermost surface of the middle isolation region 130 may contact an uppermost surface of a spacer 170 that is on the lower gate 180b.

A width, in the horizontal direction X, of the middle isolation region 130 may be equal to that of the bottom isolation region 160, and equal to that of each of the channel layers 120. The width may be, for example, about 20 nanometers (nm). The width may be wider than a width of the gates 180, as the spacers 170 may be on sidewalls of the gates 180. In some embodiments, outer sidewalls of the spacers 170 may be collinear, in the vertical direction Z, with sidewalls of the middle isolation region 130, sidewalls of the bottom isolation region 160, and sidewalls of the channel layers 120.

The upper and lower transistors Ta, Tb may be different types of MOSFETs. For example, the upper and lower transistors Ta, Tb may be PMOS and NMOS transistors, respectively, or vice versa. As an example, PMOS and NMOS transistors may be provided by S/D regions comprising silicon germanium and silicon carbide, respectively. The middle isolation region 130 separates the lower channel layers 120b of the lower transistor Tb from the upper channel layers 120a of the upper transistor Ta.

According to some embodiments, an insulating layer 112 may be in a recess of the substrate 110. An insulating layer 114 may also be in the recess, and may be on the insulating layer 112. In some embodiments, the insulating layer 112 may comprise a different insulating material from that of the insulating layer 114. As an example, the insulating layer 112 may comprise a nitride (e.g., silicon nitride), and the insulating layer 114 may comprise an oxide (e.g., silicon oxide).

For simplicity of illustration, the lower S/D regions 140 and the upper S/D regions 150 are omitted from view in FIG. 1B. For further simplicity of illustration, a gate insulation layer is omitted from view in FIG. 1B. It will be understood, however, that a gate insulation layer may extend between each channel layer 120 and a gate 180. The gate insulation layer may wrap around each channel layer 120 and may be thinner than the spacers 170.

FIGs. 1C-1H are cross-sectional views of different examples of the middle isolation region 130 of FIG. 1B. In each of these cross-sections, the inner portion 132 is bounded by the outer portion 134 on at least two sides, such as at least an upper side and a lower side that is opposite the upper side. For simplicity of illustration, these cross-sections are not repeated for the bottom isolation region 160 of FIG. 1B. It will be understood, however, that any of the cross-sections/arrangements shown in FIGs. 1C-1H may be implemented with the bottom isolation region 160. Accordingly, the inner portion 162 (FIG. 1B) of the bottom isolation region 160 may be bounded by the outer portion 164 (FIG. 1B) in any of the ways that the inner portion 132 of the middle isolation region 130 is bounded by the outer portion 134 in FIGs. 1C-1H.

As shown in FIG. 1C, a cross-section of an inner portion 132a of the middle isolation region 130 may be bounded the outer portion 134 on more than two sides. For example, FIG. 1C shows that the inner portion 132a is bounded by the outer portion 134 on four sides. As an example, the outer portion 134 extends continuously around the perimeter of the inner portion 132a in the cross-section shown in FIG. 1C.

As shown in FIG. 1D, an inner portion 132b differs from the inner portion 132a (FIG. 1C), in that the inner portion 132b has opposite ends, in the horizontal direction X, that are tapered. The inner portion 132b is thus thinner, in the vertical direction Z, at its ends than at a middle portion that is between the ends. In contrast, the inner portion 132a has a rectangular shape. A thickness, in the vertical direction Z, of the inner portion 132a may therefore be constant.

The inner portions 132a, 132b may each comprise a vacancy, such as an air gap. In some embodiments, a gas other than air may be in the vacancy. The vacancy is thus not limited to including air. Accordingly, the vacancy may include various gases. The vacancy is not, however, filled with a solid material, but rather comprises only (or at least predominantly) gas.

As shown in FIG. 1E, a cross-section of an inner portion 132c has a rectangular shape. The inner portion 132c is different from the inner portion 132a (FIG. 1C), in that the inner portion 132c comprises a solid insulating material instead of a vacancy. The insulating material is a different material from that of the outer portion 134. For example, the insulating material of the inner portion 132c may comprise an oxide, such as silicon oxide.

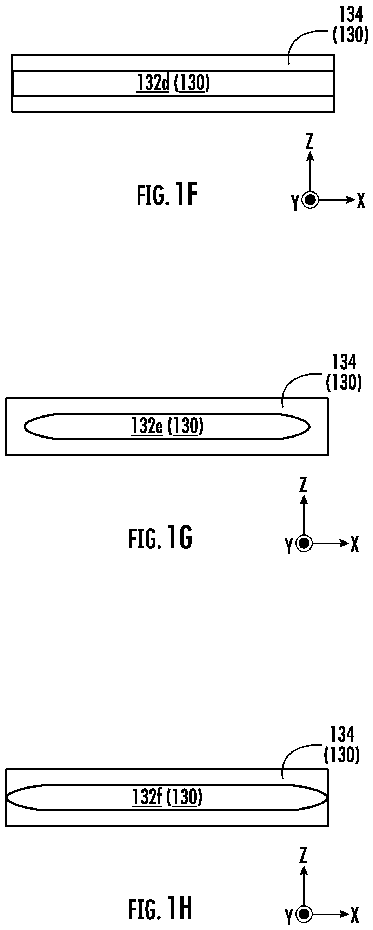

As shown in FIG. 1F, a cross-section of an inner portion 132d is bounded by the outer portion 134 on only two sides (e.g., opposite sides). The outer portion 134 may be separated or segmented into an upper outer portion and a lower outer portion that are not in contact with each other. As an example, the upper outer portion of the outer portion 134 may contact an upper surface of the inner portion 132d, and may have a width, in the horizontal direction X, that is equal to a width of the inner portion 132d. Similarly, the lower outer portion of the outer portion 134 may contact a lower surface of the inner portion 132d, and may have a width, in the horizontal direction X, that is equal to a width of the inner portion 132d. Because the inner portion 132d includes a solid insulating material instead of a vacancy, the cross-section of the inner portion 132d shown in FIG. 1F does not need to be bounded by the outer portion 134 on more than two sides.

As shown in FIG. 1G, an inner portion 132e includes a solid insulating material instead of a vacancy, and has the same cross-sectional shape as the inner portion 132b (FIG. 1D). Accordingly, the inner portion 132e has opposite tapered ends.

As shown in FIG. 1H, an inner portion 132f differs from the inner portion 132e (FIG. 1G), in that it is wider, in the horizontal direction X, than the inner portion 132e. For example, opposite tapered ends of the inner portion 132f may extend to opposite ends, respectively, of the outer portion 134. The inner portion 132f may thus have a width (e.g., a maximum width) equal to that of the outer portion 134. Moreover, the tapered ends of the inner portion 132f may, in some embodiments, not be covered by the outer portion 134.

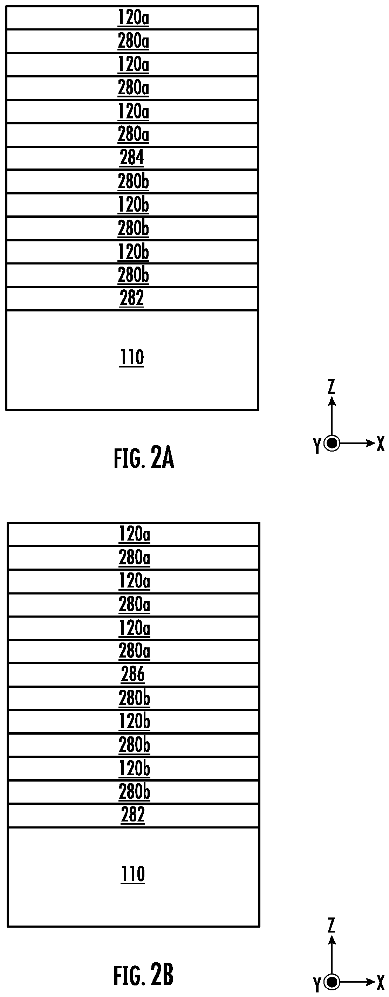

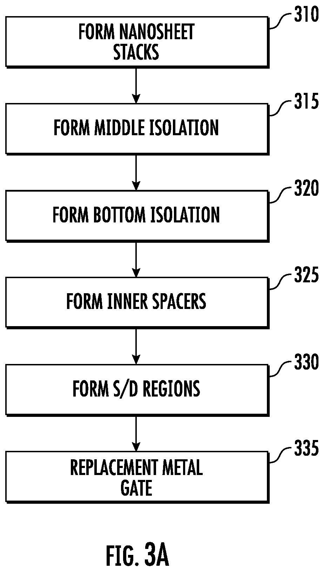

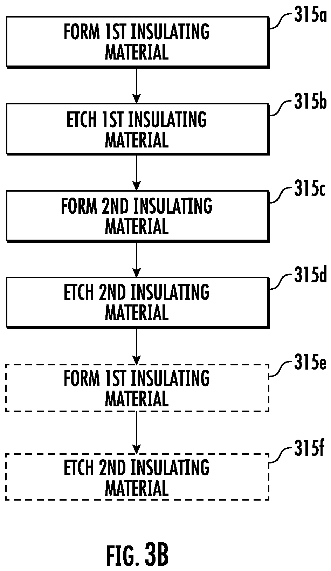

FIGs. 2A-2D are cross-sectional views illustrating operations of forming the transistor stack 101 of FIG. 1B. FIGs. 3A and 3B are flowcharts corresponding to the operations shown in FIGs. 2A-2D. FIG. 3B shows example details of Block 315 of FIG. 3A.

As shown in FIGs. 2A and 3A, the operations may include forming (Block 310) stacks of semiconductor (e.g., silicon) channel layers 120 on a substrate 110. In some embodiments, the channel layers 120 may be nanosheets, and the stacks may thus be nanosheet stacks. The channel layers 120 may be separated or segmented into a lower stack, which comprises lower channel layers 120b, and an upper stack, which comprises upper channel layers 120a. The lower stack is separated from the upper stack by a middle sacrificial layer 284.

The lower stack and the upper stack may collectively provide a single stack of semiconductor layers that alternate with sacrificial gate layers 280. The sacrificial gate layers 280 include upper sacrificial gate layers 280a and lower sacrificial gate layers 280b. The upper sacrificial gate layers 280a may be alternately stacked on the substrate 110 with the channel layers 120a, and the lower sacrificial gate layers 280b may be alternately stacked on the substrate 110 with the channel layers 120b. The middle sacrificial layer 284 may be between, in the vertical direction Z, an uppermost one of the sacrificial gate layers 280b and a lowermost one of the sacrificial gate layers 280a.

A bottom sacrificial layer 282 may be between, in the vertical direction Z, the substrate 110 and a lowermost one of the sacrificial gate layers 280b. The sacrificial layers 282, 284 may have a higher germanium concentration than the sacrificial gate layers 280. For example, the sacrificial gate layers 280 may comprise silicon germanium that is epitaxially grown from the channel layers 120 and has a germanium concentration of 20-25%, and the bottom sacrificial layer 282 may comprise silicon germanium that is epitaxially grown from the substrate 110 and has a higher germanium concentration (e.g., 50-55% germanium). Moreover, the middle sacrificial layer 284 may comprise silicon germanium that is epitaxially grown from the uppermost one of the sacrificial gate layers 280b and the lowermost one of the sacrificial gate layers 280a and has a higher germanium concentration than that of the sacrificial gate layers 280.

In some embodiments, the germanium concentration of the middle sacrificial layer 284 may be different from (e.g., lower than) that of the bottom sacrificial layer 282. The middle sacrificial layer 284 may thus have an etch selectivity relative to the bottom sacrificial layer 282. As a result, in a subsequent operation, the middle sacrificial layer 284 may be removed at a different time from when (e.g., before) the bottom sacrificial layer 282 is removed.

In other embodiments, the germanium concentration of the middle sacrificial layer 284 may be the same as that of the bottom sacrificial layer 282. Accordingly, the middle sacrificial layer 284 and the bottom sacrificial layer 282 may be removed concurrently. Moreover, in a subsequent process, an inner portion 132 (FIG. 1B) of a middle isolation region 130 and an inner portion 162 (FIG. 1B) of a bottom isolation region 160 may be formed concurrently in locations that were previously occupied by the middle sacrificial layer 284 and the bottom sacrificial layer 282, respectively.

According to some embodiments, a lowermost one of the sacrificial gate layers 280b may be epitaxially grown either from a lowermost one of the channel layers 120b or from the bottom sacrificial layer 282. In some embodiments, a lowermost surface of the bottom sacrificial layer 282 may contact an uppermost surface of the substrate 110, and an uppermost surface of the bottom sacrificial layer 282 may contact a lowermost surface of the lowermost one of the sacrificial gate layers 280b.

The upper stack (including upper channel layers 120a) and the lower stack (including lower channel layers 120b) each form part of the transistor stack 101. The lower channel layers 120b form part of a lower transistor Tb (FIG. 1A) of the transistor stack 101, and the upper channel layers 120a form part of an upper transistor Ta (FIG. 1A) of the transistor stack 101. Multiple transistor stacks 101 may be on the substrate 110 and spaced apart from each other in the direction Y (and/or in the direction X). Accordingly, operations of forming the transistor stacks 101 may include forming multiple stacks of channel layers 120 that are spaced apart from each other in the direction Y (and/or in the direction X).

In a subsequent process/operation, the sacrificial gate layers 280 may be replaced with a gate 180 (FIG. 1B). Moreover, the middle sacrificial layer 284 may be replaced with a middle isolation (e.g., MDI) region 130 (FIG. 1B) in a subsequent process/operation, and the bottom sacrificial layer 282 may be replaced with a bottom isolation (e.g., BDI) region 160 (FIG. 1B) in a subsequent process/operation. Because a germanium concentration of the sacrificial gate layers 280 may be different from a germanium concentration of the sacrificial layers 282, 284, the sacrificial gate layers 280 may have an etch selectivity relative to the sacrificial layers 282, 284. Also, the sacrificial gate layers 280, the bottom sacrificial layer 282, and the middle sacrificial layer 284 may each have an etch selectivity with respect to the channel layers 120.

As shown in FIGs. 2B-2D and 3A, the middle sacrificial layer 284 may be removed and replaced (Block 315) with a middle isolation region 130, which includes an inner portion 132c and an outer portion 134. For example, the middle sacrificial layer 284 may be removed by selectively etching the middle sacrificial layer 284 relative to the sacrificial gate layers 280, the channel layers 120, and the bottom sacrificial layer 282. Accordingly, an opening 286 may be formed between the lowermost one of the upper sacrificial gate layers 280a and the uppermost one of the lower sacrificial gate layers 280b. The opening 286 may expose a lower surface of the lowermost one of the upper sacrificial gate layers 280a and an upper surface of the uppermost one of the lower sacrificial gate layers 280b, as shown in FIG. 2B.

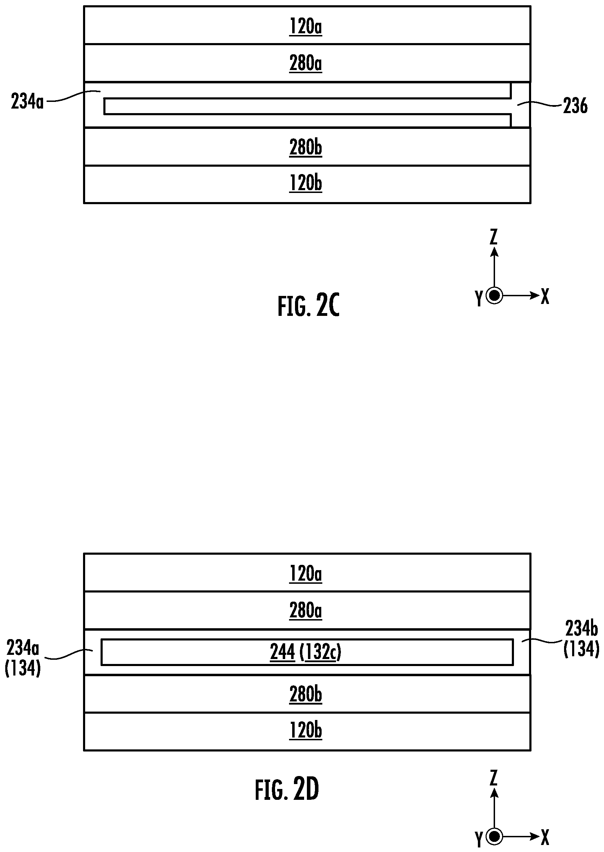

The middle isolation region 130 is formed in the opening 286. FIGs. 2C and 3B show that a first insulating material 234a may be formed (Block 315a) in the opening 286. As an example, the insulating material 234a may be deposited to contact the exposed lower surface of the lowermost one of the upper sacrificial gate layers 280a and the exposed upper surface of the uppermost one of the lower sacrificial gate layers 280b. A deposition method for the insulating layer 234a may be either a method with relatively low coverage (e.g., anisotropic growth) or a method with relatively high coverage (e.g., isotropic growth, such as Atomic Layer Deposition (ALD)). The insulating material 234a may include, for example, silicon boron carbonitride.

After deposition, the insulating material 234a may be etched (Block 315b) to remove one or more portions of the insulating material 234a. As an example, a wet etch may be used to remove a sidewall of the insulating material 234a, while other portions of the insulating material 234a contacting the lower surface of the lowermost one of the upper sacrificial gate layers 280a and the upper surface of the uppermost one of the lower sacrificial gate layers 280b may remain, thereby facilitating the shape of the insulating material 234a shown in FIG. 2C. Etching the sidewall of the insulating material 234a may form an opening 236 that exposes a portion of the lower surface of the lowermost one of the upper sacrificial gate layers 280a and a portion of the upper surface of the uppermost one of the lower sacrificial gate layers 280b.

FIGs. 2D and 3B show that a second insulating material 244 may be formed (Block 315c) in the opening 236 and on inner surfaces of the first insulating material 234a. The first insulating material 234a (e.g., silicon boron carbonitride) is different from the second insulating material 244 (e.g., silicon oxide or another material having a lower dielectric constant than silicon boron carbonitride). After forming (e.g., depositing) the second insulating material 244, a sidewall of the second insulating material 244 may be etched (Block 315d). The etching may expose a portion of the lower surface of the lowermost one of the upper sacrificial gate layers 280a and a portion of the upper surface of the uppermost one of the lower sacrificial gate layers 280b.

The first insulating material 234a may also be referred to herein as a "first portion of the first insulating material 234," as another (i.e., second) portion of the first insulating material 234 may subsequently be formed. In some embodiments, after etching the second insulating material 244, a second portion 234b of the first insulating material 234 may be formed (Block 315e) on an exposed sidewall of the second insulating material 244 and between the lower surface of the lowermost one of the upper sacrificial gate layers 280a and the upper surface of the uppermost one of the lower sacrificial gate layers 280b. The portions 234a, 234b of the first insulating material 234 collectively provide an outer portion 134 of a middle isolation region 130 (FIG. 1B). As shown in FIG. 2D, the outer portion 134 may enclose the second insulating material 244, which thus may provide an inner portion 132c of the middle isolation region 130. The operation of Block 315e may be omitted for structures that do not include an inner portion 132 bounded by the outer portion 134 on more than two sides.

Though FIG. 2D shows an example in which a cross-section of the inner portion 132c has a rectangular shape and is bounded by the outer portion 134 on four sides, thereby providing the structure shown in FIG. 1E, any of the structures shown in FIGs. 1C, 1D, and 1F-1H may be provided based on the operations shown in FIG. 3B. For example, in some embodiments, after enclosing the second insulating material 244 by forming the second portion 234b of the first insulating material 234, the second insulating material 244 may be removed (Block 315f), thereby providing an inner portion 132a that comprises a vacancy enclosed by the outer portion 134, as shown in FIG. 1C. As an example, the second insulating material 244 may be selectively etched relative to the first insulating material 234. The operation of Block 315f may be omitted for structures that do not include a vacancy.

Moreover, depending on how the first and second insulating materials 234, 244 are deposited and/or etched, the second insulating material 244 may have opposite ends that are tapered, thereby facilitating the structure shown in FIGs. 1G and 1H (if the second insulating material 244 is not removed) and the structure shown in FIG. 1D (if the second insulating material 244 is removed). In other embodiments, etching of the first insulating material 234 before forming the second insulating material 244 may include removing opposite sidewalls of the first insulating material 234, thereby facilitating the structure shown in FIG. 1F, where a cross-section of the second insulating material 244 (an inner portion 132d of the middle isolation region 130) is bounded by the first insulating material 234 (an outer portion 134 of the middle isolation region 130) on only two (top and bottom) sides.

As shown in FIG. 3A, after forming the middle isolation region 130, a bottom isolation region 160 (FIG. 1B) may be formed (Block 320). The bottom sacrificial layer 282 may be removed and replaced with the bottom isolation region 160, which includes an inner portion 162 and an outer portion 164, as shown in FIG. 1B. A process of forming the bottom isolation region 160 may be analogous to that shown in FIGs. 2B-2D and 3B with respect to the middle isolation region 130. For example, the bottom sacrificial layer 282 may be removed by selectively etching the bottom sacrificial layer 282 relative to the sacrificial gate layers 280, the channel layers 120, and the middle isolation region 130. Accordingly, the bottom isolation region 160 may be formed between (and in contact with) the substrate 110 and a lowermost one of the sacrificial gate layers 280b, while the middle isolation region 130 separates the upper channel layers 120a from the lower channel layers 120b (and while the sacrificial gate layers 280 remain between the channel layers 120). Moreover, the inner portion 162 and the outer portion 164 of the bottom isolation region 160 may be formed by a process analogous to that for forming the inner portion 132 and the outer portion 134 of the middle isolation region 130.

Referring still to FIG. 3A, the sacrificial gate layers 280 may be narrowed, in the direction X, to form openings between the channel layers 120. As an example, sidewalls of the sacrificial gate layers 280 may be selectively etched relative to sidewalls of the bottom isolation region 160, the channel layers 120, and the middle isolation region 130. An insulating layer may be formed in the openings and on sidewalls of the channel layers 120. In some embodiments, the insulating layer and the bottom isolation region 160 may include the same insulating material (e.g., silicon nitride). Insulating inner spacers 170 (FIG. 1B) may be formed (Block 325) by selectively removing portions of the insulating layer that are outside of the openings. Accordingly, the selective removal may expose sidewalls of the channel layers 120. In some embodiments, the selective removal may include vertically, but not laterally, etching the insulating layer.

As shown in FIGs. 1B and 3A, lower S/D regions 140 and upper S/D regions 150 may be formed (Block 330) after forming the spacers 170. For example, the lower S/D regions 140 may be epitaxially grown from the substrate 110 and/or the lower channel layers 120b. The lower S/D regions 140 may be on sidewalls of the bottom isolation region 160 and on sidewalls of the lower channel layers 120b. In some embodiments, the upper source/drain regions 150 may be formed after forming the lower S/D regions 140. As an example, the upper S/D regions 150 may be epitaxially grown from the upper channel layers 120a.

According to some embodiments, the channel layers 120 may comprise silicon, and the lower S/D regions 140 and/or the upper S/D regions 150 may comprise silicon, silicon carbide, or silicon germanium. Moreover, the upper S/D regions 150 may comprise a material different from that of the lower S/D regions 140. For example, the upper S/D regions 150 may comprise silicon germanium, and the lower S/D regions 140 may comprise silicon (without germanium) or silicon carbide.

Referring still to FIGs. 1B and 3A, a gate-forming process, such as a replacement metal gate (RMG) process (Block 335), may be performed after forming the S/D regions 140, 150. The gate-forming process includes removing the sacrificial gate layers 280 and replacing them with conductive material (e.g., metal), thereby forming the gates 180a, 180b. The sacrificial gate layers 280 may be removed from between the channel layers 120, as the sacrificial gate layers 280 may have an etch selectivity relative to the channel layers 120. Metal (e.g., a metal layer or respective metal layers) may then be formed on the upper and lower stacks of channel layers 120. A gate insulation layer may, according to some embodiments, be formed between the metal and the channel layers 120.

Transistor devices 100 (FIG. 1A) according to embodiments herein may provide a number of advantages. These advantages include reducing capacitance by replacing single-layer MDI and BDI regions with a middle isolation region 130 (FIG. 1B) and a bottom isolation region 160 (FIG. 1B) that each include an inner portion having an oxide (or another material having a lower dielectric constant than silicon nitride and/or lower than silicon boron carbonitride) or a vacancy. In contrast, conventional MDI and BDI regions may each have only a single layer, which may be a high-dielectric-constant material, such as silicon nitride or silicon boron carbonitride. By reducing capacitance with respect to the middle isolation region 130 and/or the bottom isolation region 160, performance of the transistor devices 100 can be improved.

Referring to FIGs. 1C-1H, an inner portion of each of the middle isolation region 130 and the bottom isolation region 160 may have various shapes and may be bounded by an outer portion in various ways. The middle isolation region 130 and the bottom isolation region 160 may be multi-layer isolation regions comprising different first and second insulating materials, as shown in FIGs. 1E-1H, or may comprise a vacancy (e.g., an air gap), as shown in FIGs. 1C and 1D. In some embodiments, an inner portion 132 (FIG. 1B) of the middle isolation region 130 and an inner portion 162 (FIG. 1B) of the bottom isolation region 160 may each comprise a solid insulating material (e.g., silicon oxide). In other embodiments, the inner portions 132, 162 may each comprise a vacancy. In further embodiments, the inner portion 162 may comprise a vacancy, and the inner portion 132 may comprise a solid insulating material, or vice versa.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

The above-disclosed subject matter is to be considered illustrative, and not restrictive, and the appended claims are intended to cover all such modifications, enhancements, and other embodiments, which fall within the scope of the present invention. Thus, to the maximum extent allowed by law, the scope is to be determined by the broadest permissible interpretation of the following claims and their equivalents, and shall not be restricted or limited by the foregoing detailed description.

## Claims

1. A transistor device comprising:
a substrate;
a transistor stack on the substrate, the transistor stack comprising a lower transistor and an upper transistor that is on top of the lower transistor, wherein the upper transistor and the lower transistor each comprise semiconductor channel layers;
a bottom isolation region between the substrate and the semiconductor channel layers of the lower transistor; and
a middle isolation region between the upper transistor and the lower transistor,
wherein the middle isolation region and the bottom isolation region each have an inner portion that has a dielectric constant that is lower than that of silicon nitride and lower than that of silicon boron carbonitride.

2. The transistor device of Claim 1, wherein the inner portion of the middle isolation region and/or of the bottom isolation region comprises an oxide or a vacancy.

3. The transistor device of Claim 2, wherein the inner portion of the middle isolation region and/or of the bottom isolation region comprises silicon oxide.

4. The transistor device of any one of Claims 1 to 3, wherein the inner portion of the middle isolation region and/or of the bottom isolation region is free of carbon and free of nitrogen.

5. The transistor device of any one of Claims 1 to 4,
wherein an outer portion of each of the middle isolation region and the bottom isolation region comprises a nitride, and
wherein a cross-section of the inner portion of the middle isolation region and/or of the bottom isolation region is bounded by the respective outer portion on at least two sides.

6. The transistor device of Claim 5, further comprising:
an upper gate between the semiconductor channel layers of the upper transistor; and
a lower gate between the semiconductor channel layers of the lower transistor,
wherein the inner portion of the middle isolation region is spaced apart from the upper gate and the lower gate by the outer portion of the middle isolation region, and
wherein the inner portion of the bottom isolation region is spaced apart from the lower gate by the outer portion of the bottom isolation region.

7. The transistor device of Claim 5 or 6, wherein the cross-section of the inner portion of the middle isolation region and/or of the bottom isolation region has a rectangular shape.

8. The transistor device of any one of Claims 5 or 6, wherein the cross-section of the inner portion of the middle isolation region and/or of the bottom isolation region has opposite tapered ends.

9. The transistor device of any one of Claims 5 to 8, wherein the cross-section of the inner portion of the middle isolation region and/or of the bottom isolation region is bounded by the respective outer portion on an upper surface and a lower surface of the inner portion and not on sidewalls of the inner portion.

10. The transistor device of any one of Claims 5 to 8, wherein the cross-section of the inner portion of the middle isolation region and/or of the bottom isolation region is bounded by the respective outer portion on four sides.

11. The transistor device of any one of Claims 5 to 10, wherein the outer portion of the middle isolation region comprises a first insulating material that is different from a second insulating material of the outer portion of the bottom isolation region.

12. A method of forming a transistor device, the method comprising:
forming a middle isolation region that separates upper semiconductor channel layers of an upper transistor from lower semiconductor channel layers of a lower transistor,
wherein forming the middle isolation region comprises:
forming a first insulating material between the upper semiconductor channel layers and the lower semiconductor channel layers; and
forming a second insulating material between an upper surface and a lower surface of the first insulating material, and
wherein the second insulating material comprises a lower dielectric constant than the first insulating material.

13. The method of Claim 12, further comprising forming a bottom isolation region between a substrate and the lower semiconductor channel layers,
wherein forming the bottom isolation region comprises:
forming a third insulating material between the substrate and the lower semiconductor channel layers; and
forming another portion of the second insulating material between an upper surface and a lower surface of the third insulating material, and
wherein the dielectric constant of the second insulating material is lower than that of the third insulating material.

14. The method of Claim 12 or 13,
wherein the dielectric constant of the second insulating material is lower than that of silicon nitride and lower than that of silicon boron carbonitride, and
wherein forming the middle isolation region further comprises forming another portion of the first insulating material on a sidewall of the second insulating material and between the upper semiconductor channel layers and the lower semiconductor channel layers.

15. The method of any one Claims 12 to 14, wherein forming the middle isolation region further comprises using an etchant that has an etch selectivity between the first insulating material and the second insulating material to remove the second insulating material and thereby form a vacancy.
